# EUROPÄISCHE PATENTSCHRIFT

(11) **EP 2 713 397 B1**
(45) Veröffentlichungstag und Bekanntmachung des Hinweises auf die Patenterteilung: **15.08.2018**
(21) Anmeldenummer: 13185764.1
(22) Anmeldetag: 24.09.2013
(51) Int. Cl.: H01L 25/075, F21Y 105/00, H01L 33/54, H01L 33/58, F21V 5/04

(54) **Optische Anordnung und Beleuchtungsvorrichtung mit optischer Anordnung**
Optical arrangement and illumination device with an optical arrangement
Dispositif optique et un dispositif d'éclairage avec un dispositif optique

(30) Priorität: 26.09.2012 DE 102012109111
(43) Veröffentlichungstag der Anmeldung: 02.04.2014
(73) Patentinhaber: OSRAM GmbH, 80807 München (DE)
(72) Erfinder: Markytan, Ales, 93055 Regensburg (DE); Gärtner, Christian, 93055 Regensburg (DE); Linkov, Alexander, 93059 Regensburg (DE); Mönch, Wolfgang, 93080 Pentling (DE); Schulz, Roland, 93059 Regensburg (DE); Heinemann, Erik, 93055 Regensburg (DE)
(74) Vertreter: Epping - Hermann - Fischer

(56) Entgegenhaltungen:
- US-A1- 2006 067 640
- US-A1- 2007 109 779
- US-A1- 2012 140 461

## Beschreibung

Es wird eine optische Anordnung angegeben. Darüber hinaus wird eine Beleuchtungsvorrichtung mit einer optischen Anordnung angegeben.
Diese Patentanmeldung beansprucht die Priorität der deutschen Patentanmeldung 10 2012 109 111.0. Druckschrift US 2007/0109779 A1 beschreibt eine Beleuchtungsvorrichtung, die eine Mehrzahl von farbigen LED-Einheiten aufweist, welche von einem optischen Element in Form einer Linse abgedeckt sind, wobei ein innerer die LED-Einheiten überdeckender Bereich der Linse eine Vertiefung aufweist, wodurch eine Umlenkung der von den LED-Einheiten abgestrahlten Strahlung aufgrund von Brechung an Außenflächen der Linse an der Vertiefung erzielt wird. Weitere Druckschriften US 2006/0067640 A1 und US 2012/0140461 A1 beschreiben jeweils eine Beleuchtungsvorrichtung mit modifizierten Abdecklinsen zur Erzielung einer möglichst gleichmäßigen Strahlungsverteilung.
Es ist eine zu lösende Aufgabe der vorliegenden Anmeldung eine besonders effiziente optische Anordnung anzugeben. Ferner ist es eine zu lösende Aufgabe der vorliegenden Anmeldung eine Beleuchtungsvorrichtung anzugeben, die besonders effizient und einfach aufgebaut ist.

Diese Aufgabe wird durch die optische Anordnung mit den Merkmalen des Anspruchs 1 und durch die Beleuchtungsvorrichtung mit den Merkmalen des Anspruchs 14 gelöst.

Gemäß einem Aspekt wird eine optische Anordnung, kurz Anordnung, angegeben. Die optische Anordnung ist zur Abstrahlung elektromagnetischer Strahlung, vorzugsweise von Licht, ausgebildet. Die optische Anordnung strahlt vorzugsweise farbiges Licht ab. Alternativ dazu kann die optische Anordnung aber auch weißes Licht abstrahlen.

Die optische Anordnung weist einen Träger auf. Die optische Anordnung weist ferner eine Mehrzahl von Halbleiterchips auf.

Die optische Anordnung kann beispielsweise zwei, drei oder auch mehr Halbleiterchips, zum Beispiel 10 bis 200 Halbleiterchips, aufweisen.

Bei den Halbleiterchips handelt es sich vorzugsweise um auf einem III-V-Halbleitermaterial basierende Halbleiterchips. Vorzugsweise sind die Halbleiterchips Leuchtdioden (LED) Chips. Die Halbleiterchips weisen jeweils eine aktive Zone zur Erzeugung von elektromagnetischer Strahlung, insbesondere von Licht, auf. Die Halbleiterchips strahlen vorzugsweise farbiges, beispielsweise blaues, rotes, grünes oder mintgrün-weißes Licht ab.

Es können alle Halbleiterchips baugleich sein. Alternativ ist es möglich, dass verschiedenartige, insbesondere auf verschiedenen Halbleitermaterialien basierende Halbleiterchips bereitgestellt werden, die bevorzugt zur Emission in verschiedenen Spektralbereichen ausgebildet sind. Beispielsweise kann ein Teil der Halbleiterchips, z.B. ein Drittel der Halbleiterchips, zur Abstrahlung von grünem Licht ausgebildet sein. Ein weiterer Teil, beispielsweise ein Drittel, der Halbleiterchips kann zur Abstrahlung von blauem Licht ausgebildet sein. Ein weiterer Teil, beispielsweise ein Drittel, der Halbleiterchips kann zur Abstrahlung von rotem Licht ausgebildet sein. Aber auch andere Kombinationen von in verschiedenen Spektralbereichen emittierenden Halbleiterchips sind möglich.

Die Halbleiterchips sind auf dem Träger angeordnet. Die Halbleiterchips sind auf dem Träger befestigt, beispielsweise angelötet. Der Träger dient zur mechanischen Stabilisierung der Halbleiterchips.

Die optische Anordnung weist ferner wenigstens ein optisches Element, beispielsweise eine Linse, auf. Vorzugsweise ist das optische Element eine Primärlinse. Die optische Anordnung kann auch zwei, drei oder mehr optische Elemente aufweisen.
Das optische Element ist den Halbleiterchips in Abstrahlungsrichtung nachgeordnet. Vorzugsweise ist das optische Element den Halbleiterchips unmittelbar nachgeordnet. Insbesondere befindet sich zwischen dem optischen Element und den Halbleiterchips kein Spalt, insbesondere kein Luftspalt. Vorzugsweise sind die Halbleiterchips in das optische Element eingebracht und vollständig von diesem umgeben. Das optische Element kann zu diesem Zweck Ausnehmungen aufweisen, in welche die Halbleiterchips eingebracht sind. Das optische Element kann aber auch auf den Halbleiterchips aufgesetzt oder aufgegossen sein.
Das optische Element ist zur Umlenkung der von den Halbleiterchips erzeugten Strahlung ausgebildet. Erfindungsgemäß ist das optische Element derart ausgebildet und angeordnet, dass ein Großteil der Strahlung in einen Winkel von größer oder gleich 70°, beispielsweise 75°, 80° oder 90°, zu einer Senkrechten der aktiven Flächen der Halbleiterchips von der optischen Anordnung abgestrahlt wird. Beispielsweise werden mindestens 50%, vorzugsweise mehr als 80%, besonders bevorzugt mehr als 90%, beispielsweise 95%, der Strahlung in einen Winkel von größer oder gleich 70° zur Senkrechten der aktiven Flächen der Halbleiterchips von der optischen Anordnung abgestrahlt.
Die Halbleiterchips sind derart angeordnet, dass eine ungleichmäßige Verteilung der Halbleiterchips auf dem Träger erreicht ist. Die Halbleiterchips sind auf dem Träger also nicht gleichmäßig verteilt. Insbesondere sind die Halbleiterchips nicht über die gesamte Montagefläche des Trägers verteilt und beispielsweise nicht an den Knotenpunkten eines regelmäßigen Gitters angeordnet. Insbesondere gibt es Bereiche auf dem Träger, also auf der den Halbleiterchips zugewandten Oberfläche des Trägers, die frei von den Halbleiterchips sind und Bereiche, in denen die Halbleiterchips gehäuft angeordnet sind. Beispielsweise können die Halbleiterchips nur in einem Randbereich oder nur in einem Mittelbereich des Trägers angeordnet sein. Vorzugsweise sind die Halbleiterchips in Form von wenigstens einer zusammenhängenden Gruppe bzw. eines Clusters bzw. einer Ansammlung auf dem Träger angeordnet. Mit anderen Worten, die Halbleiterchips sind derart auf dem Träger gruppiert, dass ein erster Bereich des Trägers frei von Halbleiterchips ist und auf einem zweiten Bereich des Trägers die Gruppe oder Ansammlung der Halbleiterchips angeordnet ist. Auf dem zweiten Bereich treten die Halbleiterchips demnach gehäuft auf. Insbesondere sind auf dem zweiten Bereich alle Halbleiterchips der optischen Anordnung angebracht. Auf dem ersten Bereich sind keine Halbleiterchips vorhanden.

Innerhalb der Gruppe oder Ansammlung der Halbleiterchips können die Abstände zwischen den einzelnen Halbleiterchips gleich sein. Alternativ können die Abstände zwischen den einzelnen Halbleiterchips innerhalb der Gruppe oder Ansammlung aber auch variieren. Alle Halbleiterchips der optischen Anordnung sind innerhalb der wenigstens einen Gruppe auf dem Träger angeordnet. Mit anderen Worten, kein Halbleiterchip ist separat oder beabstandet von einer Gruppe oder Ansammlung der Halbleiterchips angeordnet.

Auf dem Träger sind erfindungsgemäß mehrere Ansammlungen bzw. Gruppen bzw. Cluster von Halbleiterchips angeordnet. Es sind nicht alle Halbleiterchips in einer Gruppe angeordnet, sondern die Gesamtzahl der Halbleiterchips ist auf die verschiedenen Gruppen von Halbleiterchips verteilt. Jede Gruppe von Halbleiterchips kann die gleiche Zahl von Halbleiterchips aufweisen. Die Zahl der Halbleiterchips kann für die verschiedenen Gruppen kann jedoch auch unterschiedlich sein.
Die jeweilige Gruppe bzw. Ansammlung ist zusammenhängend ausgebildet. Mit anderen Worten, ist jeweils eine eindeutige Zuordnung eines Halbleiterchips zu einer Gruppe möglich. Innerhalb der einzelnen Gruppen können die Abstände der Halbleiterchips zueinander wieder gleich sein. Alternativ dazu können die Abstände zwischen den einzelnen Halbleiterchips innerhalb einer Gruppe aber auch variieren. Der Abstand zwischen den einzelnen Gruppen ist größer, als der Abstand zwischen den Halbleiterchips einer Gruppe. Zwischen den einzelnen Gruppen von Halbleiterchips ist der Träger frei von Hableiterchips. Die Zwischenräume zwischen den Gruppen bilden folglich den vorher erwähnten ersten Bereich des Trägers. Die Gruppen der Halbleiterchips sind auf dem zweiten Bereich des Trägers angeordnet.
Die ungleichmäßige Verteilung der Halbleiterchips auf dem Träger bewirkt eine ungleichmäßige Zuordnung der einzelnen Halbleiterchips zu einzelnen Segmenten des optischen Elements. Vorzugsweise sind die Halbleiterchips bzw. die Gruppen der Halbleiterchips, nur unter bzw. in einem bestimmten Segment des optischen Elements angeordnet, während unter bzw. in einem weiteren Segment des optischen Elements keine Halbleiterchips bzw. Gruppen von Halbleiterchips angeordnet sind.
Durch die gezielte, ungleichmäßige Anordnung der Halbleiterchips auf dem Träger werden nur bestimmte Segmente des optischen Elements direkt der von den Halbleiterchips emittierten Strahlung ausgesetzt. Die von den Halbleiterchips erzeugte Strahlung kann dadurch gezielt in große Winkel, beispielsweise wie oben beschrieben von 70° oder mehr zur Senkrechten der aktiven Flächen, umgelenkt werden. Dies geschieht lediglich durch geschickte Anordnung der Halbleiterchips in Kombination mit dem optischen Element. Weitere Komponenten, beispielsweise eine weitere Linse (Sekundärlinse), sind nicht erforderlich. Somit wird eine besonders effiziente optische Anordnung erreicht, die einfach aufgebaut und dadurch kostengünstig ist.
Gemäß zumindest einer Ausführungsform weist das optische Element wenigstens eine Strahlungseintrittsfläche auf. An der Strahlungseintrittsfläche tritt die von den Halbleiterchips emittierte Strahlung in das optische Element ein. Die Strahlungseintrittsfläche stellt eine Grenzfläche zwischen den Halbleiterchips und dem optischem Element dar. Die Halbleiterchips weisen vorzugsweise eine Hauptemissionsrichtung auf, die senkrecht zu einer Emissionsfläche der Halbleiterchips verläuft. Die jeweilige Emissionsfläche ist vorzugsweise eben. Die Strahlungseintrittsfläche des optischen Elements ist bevorzugt eben oder planar ausgeführt. Die Strahlungseintrittsfläche ist vorzugsweise parallel und gegenüberliegend zu den Emissionsflächen der Halbleiterchips angeordnet.

Das optische Element ist vorzugsweise einstückig ausgebildet. Zur Herstellung des optischen Elements kann ein Gussverfahren, etwa ein Spritzguss oder ein Druckguss-Verfahren, oder ein Prägeverfahren, z.B. Heißprägen, Transferprägen, angewandt werden. Vorzugsweise weist das optische Element einen Kunststoff, beispielsweise Polymethylmethacrylat (PMMA), ein Epoxid, ein Silikat, Silikon, ein Polysilikon, oder Polysilizan auf. Alternativ dazu kann das optische Element auch ein Glas aufweisen. Vorzugsweise ist das optische Element frei von Hinterschneidungen ausgeführt. Auf einen kostenintensiven Einsatz eines Schiebers in einem Gusswerkzeug bei der Herstellung des optischen Elements kann so verzichtet werden.

Das optische Element weist wenigstens ein erstes und wenigstens ein zweites Segment auf. Das erste und zweite Segment weist jeweils eine Grenzfläche auf. Die Grenzflächen stellen den Übergang zwischen dem optischen Element und beispielsweise der Umgebungsluft oder einer weiterer optischen Komponente, z.B. einem Konversionselement, dar, welche dem optischen Element in Abstrahlungsrichtung nachgeordnet sein kann. Alternativ kann ein Konversionselement auch innerhalb des optischen Elements, z.B. in Form von Phosphorpartikeln, angeordnet sein. Ein Konversionselement ist zur zumindest teilweisen Umwandlung der von den Halbleitchips emittierten Strahlung in eine elektromagnetische Sekundärstrahlung ausgebildet. Mit anderen Worten, das Konversionselement ist dazu ausgebildet die von den Halbleiterchips emittierte Strahlung teilweise oder vollständig in eine weitere Strahlung mit einer von der emittierten Strahlung unterschiedlichen Wellenlänge zu konvertieren.

Die Grenzflächen des ersten und zweiten Segments sind so angeordnet und ausgebildet, dass ein Großteil der durch die Strahlungseintrittsfläche in das optische Element eintretenden Strahlung von der Grenzfläche des ersten Segments auf die Grenzfläche des zweiten Segments reflektiert wird. Beispielsweise werden 50% oder mehr, bevorzugt 80% oder mehr, beispielsweise 90% oder 95% der Strahlung von der Grenzfläche des ersten Segments auf die Grenzfläche des zweiten Segments reflektiert.

Vorzugsweise ist das erste Segment so angeordnet und ausgebildet, dass der Großteil der durch die Strahlungseintrittsfläche eintretenden Strahlung von der Grenzfläche des ersten Segments totalreflektiert wird. Unter Totalreflektion wird in diesem Zusammenhang verstanden, dass der Winkel unter dem die Strahlung auf einen Punkt der Grenzfläche des ersten Segments trifft, bezüglich einer Tangentennormalen durch diesen Punkt größer ist als der Grenzwinkel der Totalreflektion des optischen Elements in dem jeweiligen umgebenden Medium in diesem Punkt. Für die Bemessung dieses Grenzwinkels ist jeweils die Tangentennormale in dem genannten Punkt maßgeblich.

Durch diese Ausgestaltung des ersten Segments kann eine besonders effiziente Abstrahlung oder Auskopplung der optischen Anordnung erzielt werden, da ein besonders großer Anteil, der von an der Grenzfläche des ersten Segments reflektierten Strahlung auf die Grenzfläche des zweiten Segments trifft.

Ferner sind die Grenzflächen des ersten und zweiten Segments so angeordnet und ausgebildet, dass die Strahlung von der Grenzfläche des zweiten Segments in den Winkelbereich von größer oder gleich 70°, beispielsweise 80° oder 90° zur Senkrechten der aktiven Flächen der Halbleiterchips gebrochen und dabei aus dem optischen Element ausgekoppelt wird. Folglich verlässt ein Großteil, beispielsweise 80%, 90%, oder 95%, der von den Halbleiterchips erzeugten Strahlung unter einem Winkel von größer oder gleich 70° das optische Element. Somit wird die von den Halbleiterchips emittierte Strahlung, die über die Strahlungseintrittsfläche in das optische Element eintritt, zumindest teilweise rückwärtig geformt oder abgelenkt. Dadurch kann vorteilhafterweise auf eine Sekundäroptik (z.B. eine Sekundärlinse), welche ebenso eine zum Strahlungseintritt in das optische Element teilweise entgegen gesetzte Strahlformung oder Ablenkung bewirken könnte, verzichtet werden. Somit kann eine hohe optische Effizienz mit nur wenigen Komponenten erzielt werden.

Gemäß zumindest einer Ausführungsform umgibt das optische Element die Halbleiterchips vollständig. Vorzugsweise sind die Halbleiterchips wie oben erwähnt in dem optischen Element eingebettet. Das optische Element ist so ausgebildet, dass die Halbleiterchips vollständig innerhalb des ersten Segments angeordnet sind. Mit anderen Worten, alle Halbleiterchips sind dem ersten Segment zugeordnet. Das heißt die Gruppe oder die Gruppen von Halbleiterchips ist bzw. sind vollständig im ersten Segment angeordnet. Das zweite Segment ist frei von Halbleiterchips. Somit kann die oben beschriebene ungleichmäßige Verteilung der Halbleiterchips erreicht werden.

Gemäß zumindest einer Ausführungsform ist das wenigstens eine erste Segment in einem Bereich von -60° bis +60° zur Senkrechten der aktiven Flächen der Halbleiterchips ausgebildet. Mit anderen Worten, das optische Element ist in dem Bereich von -60° bis +60° vorzugsweise totalreflektierend ausgebildet, so dass in diesem Bereich keine oder fast keine Strahlung aus dem optischen Element ausgekoppelt wird. Dadurch wird die oben beschriebene Strahlformung bzw. Umlenkung erreicht und eine besonders effektive Anordnung bereit gestellt.
Gemäß zumindest einer Ausführungsform ist die Grenzfläche des ersten Segments gegenüberliegend zu der Strahlungseintrittsfläche angeordnet. In Draufsicht auf das optische Element ist die Grenzfläche des ersten Segments folglich über der Strahlungseintrittsfläche und damit auch über den Halbleiterchips angeordnet.
Gemäß zumindest einer Ausführungsform sind die Halbleiterchips derart auf dem Träger angeordnet, und/oder ist das optische Element derart ausgebildet und angeordnet, dass die Abstrahlung der optischen Anordnung in zwei einander gegenüberliegende Vorzugsrichtungen erfolgt. Beispielsweise erfolgt eine Auskopplung der Strahlung aus dem optischen Element beidseitig in Richtung einer lateralen Haupterstreckungsrichtung der optischen Anordnung. Zu diesem Zweck kann dem ersten Segment in Richtung der lateralen Haupterstreckungsrichtung der optischen Anordnung beidseitig jeweils ein zweites Segment nachgeordnet sein. Da das optische Element einstückig ausgebildet ist, sind die einzelnen Segmente zusammenhängend ausgebildet.

Das optische Element ist erfindungsgemäß bezüglich einer Symmetrieachse bzw. Symmetrieebene, welche sich in einer vertikalen Richtung durch das optische Element, vorzugsweise durch das erste Segment, hindurch erstreckt symmetrisch aufgebaut. Die Halbleiterchips sind um die Symmetrieachse bzw.

Symmetrieebene des optischen Elements herum innerhalb des ersten Segments angeordnet bzw. gruppiert. Die an das erste Segment angrenzenden zweiten Segmente sind, wie oben beschrieben, frei von Halbleiterchips.
In diesem Zusammenhang wird der Begriff "laterale Ausdehnung" eingeführt, der eine Ausdehnung der optischen Anordnung entlang der lateralen Haupterstreckungsrichtung bezeichnet. Die "laterale Ausdehnung" bezeichnet folglich eine Breite der Anordnung. "Vertikale Richtung" ist im Folgenden eine Richtung senkrecht zur Haupterstreckungsrichtung des Anschlussträgers. Eine vertikale Ausdehnung der optischen Anordnung bezeichnet eine Höhe der Anordnung. "Horizontale Richtung" bezeichnet im Folgenden ebenso wie die vertikale Richtung eine Richtung senkrecht zur Haupterstreckungsrichtung des Anschlussträgers, jedoch verläuft die horizontale Richtung in der gleichen Ebene wie die laterale Haupterstreckungsrichtung. "Horizontale Ausdehnung" bezeichnet in diesem Zusammenhang folglich eine Tiefe der Anordnung.
Gemäß zumindest einer Ausführungsform sind die Halbleiterchips derart auf dem Träger angeordnet, und/oder ist das optische Element derart ausgebildet und angeordnet, dass die von der optischen Anordnung abgestrahlte Strahlung isotrop, also richtungsunabhängig, ist. Mit anderen Worten, die Strahlung wird gleichmäßig und in alle Richtungen aus dem optischen Element ausgekoppelt. Zu diesem Zweck ist das erste Segment vollständig von dem zweiten Segment umgeben. Mit anderen Worten in lateraler Richtung sowie in horizontaler Richtung ist dem ersten Segment das wenigstens eine zweite Segment nachgeordnet, so dass das erste Segment vollständig von dem zweiten Segment umgeben ist.

Auch in dieser Ausführungsform ist das optische Element bezüglich einer Symmetrieachse bzw. Symmetrieebene, welche sich in vertikale Richtung durch das optische Element, vorzugsweise durch das erste Segment, hindurch erstreckt symmetrisch aufgebaut. Die Halbleiterchips sid wiederum um die Symmetrieachse bzw. Symmetrieebene des optischen Elements herum innerhalb des ersten Segments angeordnet bzw. gruppiert. Die an das erste Segment angrenzenden zweiten Segmente sind frei von Halbleiterchips. Gemäß zumindest einer Ausführungsform sind die Halbleiterchips derart auf dem Träger angeordnet, und/oder ist das optische Element derart ausgebildet und angeordnet, dass ein Großteil, vorzugsweise 80% oder mehr, beispielsweise 90% oder 95%, der von der optischen Anordnung abgestrahlten Strahlung in einem Winkelbereich von größer oder gleich 90°, beispielsweise 95° oder 98°, zur Senkrechten der aktiven Flächen der Halbleiterchips abgestrahlt wird.

Zu diesem Zweck, in nicht zur Erfindung gehörenden Beispielen, das erste Segment in einem Randbereich des optischen Elements angeordnet sein. Mit anderen Worten, das erste Segment ist in diesem Fall nur teilweise von dem zweiten Segment umgeben. In diesem Fall weist das optische Element keine symmetrische Form auf. Die Halbleiterchips können in einem Randbereich des Trägers innerhalb des ersten Segments angeordnet bzw. gruppiert sein. Das an das erste Segment angrenzende zweite Segment ist frei von Halbleiterchips.
Gemäß zumindest einer Ausführungsform sind die Halbleiterchips derart auf dem Träger angeordnet, und/oder ist das optische Element derart ausgebildet und angeordnet, dass die optische Anordnung zur homogenen Ausleuchtung einer eckigen Fläche geeignet ist. Beispielsweise kann die optische Anordnung zur homogenen Ausleuchtung eines Quadrats oder eines Vierecks oder eines Achtecks geeignet sein.
Hierbei kann das optische Element wiederum bezüglich einer Symmetrieachse bzw. Symmetrieebene, welche sich in vertikale Richtung durch das optische Element, vorzugsweise durch das erste Segment, hindurch erstreckt symmetrisch aufgebaut sein. Das erste Segment ist erfindungsgemäß vollständig von dem zweiten Segment umgeben. Das heißt angrenzend an das erste Segment ist in lateraler und horizontaler Richtung das zweite Segment nachgeordnet. Die Halbleiterchips sind um die Symmetrieachse bzw. Symmetrieebene des optischen Elements herum an einem an das zweite Segment angrenzenden Randbereich des ersten Segments angeordnet, in Gruppen angeordnet bzw. gruppiert.
Vorzugsweise entspricht eine Anzahl von Gruppen einer Anzahl von Ecken der auszuleuchtenden Fläche. Beispielsweise kann das erste Segment zur Ausleuchtung eines Quadrats einen quadratischen Querschnitt aufweisen. An jeder Ecke dieses quadratisch ausgebildeten ersten Segments ist dann vorzugsweise eine Gruppe von Halbleiterchips angeordnet.
Der Träger ist in einem Bereich, der dem oben beschriebenen ersten Bereich entspricht, zwischen den Gruppen frei von Halbleiterchips. Das zweite Segment des optischen Elements ist frei von Halbleiterchips.
Gemäß einem weiteren Aspekt wird eine Beleuchtungsvorrichtung angegeben. Die Beleuchtungsvorrichtung ist vorzugsweise zur Beleuchtung von Flächen ausgebildet. Die Beleuchtungsvorrichtung kann eine Flächenleuchte sein. Die Beleuchtungsvorrichtung strahlt elektromagnetische Strahlung, insbesondere Licht, ab. Vorzugsweise strahlt die Beleuchtungsvorrichtung weißes Licht ab.

Die Beleuchtungsvorrichtung weist wenigstens eine wie oben beschriebene optische Anordnung auf. Sämtliche für die optische Anordnung offenbarten Merkmale sind demnach auch für die Beleuchtungsvorrichtung offenbart und umgekehrt. Die Beleuchtungsvorrichtung kann auch mehr als eine optische Anordnung, beispielsweise zwei, drei, vier oder fünf optische Anordnungen aufweisen.

Die Beleuchtungsvorrichtung weist ferner ein Gehäuse auf. Das Gehäuse weist einen Boden auf. Der Boden ist reflektierend ausgebildet. Der Boden kann eine Oberflächenstruktur aufweisen. Beispielsweise ist der Boden wellenförmig strukturiert. Das Gehäuse weist ferner eine Wand auf. Die Wand ist reflektierend ausgebildet. Die Wand kann eine Oberflächenstruktur aufweisen. Beispielsweise ist die Wand wellenförmig strukturiert. Die optische Anordnung ist auf dem reflektierenden Boden angeordnet und darauf befestigt, beispielsweise angeklebt oder angelötet.

Der reflektierende Boden und/oder die reflektierende Wand sind dazu ausgebildet, die von der optischen Anordnung abgestrahlte Strahlung gerichtet, d.h. spekular, oder ungerichtet, d.h. diffus, zu reflektieren und/oder zu streuen. Vorzugsweise reflektiert und/oder streut der reflektierende Boden bzw. die reflektierende Wand die von der optischen Anordnung abgestrahlte Strahlung diffus, also in alle Richtungen. Auf diese Weise kann die oben erwähnte Fläche besonders effektiv und homogen ausgeleuchtet werden.

Durch die ungleichmäßige Anordnung der Halbleiterchips auf dem Träger der optischen Anordnung wird auch eine ungleichmäßige Verteilung der Halbleiterchips über den reflektierenden Boden des Gehäuses erreicht. Insbesondere sind die Halbleiterchips innerhalb der optischen Anordnung wie oben beschrieben gruppiert. Der reflektierende Boden weist folglich einen ersten Bereich auf, in dem keine Halbleiterchips angeordnet sind. In diesem ersten Bereich kann aber dennoch zumindest teilweise eine optische Anordnung angeordnet sein, wobei in diesem Bereich die optische Anordnung bzw. der Träger frei von den Halbleiterchips ist. Insbesondere kann der Bereich der optischen Anordnung, in dem keine Halbleiterchips angebracht sind, mit dem ersten Bereich des reflektierenden Bodens zusammenfallen.

Der reflektierende Boden weist ferner einen zweiten Bereich auf, auf dem die Halbleiterchips gehäuft, also in Gruppen oder Ansammlungen, auftreten. Insbesondere fällt der Bereich der optischen Anordnung, in dem die Halbleiterchips angebracht sind, mit dem zweiten Bereich des reflektierenden Bodens zusammen.

Insgesamt sind die Halbleiterchips in ungleichmäßigen Abständen über den reflektierenden Boden verteilt. Das heißt nicht der komplette reflektierende Boden ist mit Halbleiterchips versehen, sondern nur ein Teilbereich, der oben erwähnte zweite Bereich. Beispielsweise sind weniger als 30% des Bodens, vorzugsweise nur 20%, 10%, oder 5% des Bodens, mit in der optischen Anordnung verbauten Halbleiterchips versehen. Eine effektive und homogene Ausleuchtung von Flächen kann folglich mit einer nur geringen Anzahl ungleichmäßig über den reflektierenden Boden verteilter Halbleiterchips erwirkt werden.

In Emissionsrichtung kann die Beleuchtungsvorrichtung ferner eine Mischoptik oder Lichtformungsoptik, beispielsweise zwei gekreuzte Prismenfolien, Mikrolinsen oder Mikroprismen, aufweisen. Die Mischoptik ist dazu ausgebildet und angeordnet, das von den Halbleiterchips in verschiedenen Spektralbereichen emittierte Licht in weißes Licht umzuwandeln. Weist die optische Anordnung beispielsweise rotes, blaues und grünes Licht emittierende Halbleiterchips auf, so ist die Mischoptik dazu ausgebildet, das rote, grüne und blaue Licht derart zu mischen bzw. zu überlagern, dass von der Beleuchtungsvorrichtung weißes Licht emittiert wird ("RGB" Lösung). Weist die optische Anordnung beispielsweise rotes und mintgrün-weißes Licht emittierende Halbleiterchips auf, so ist die Mischoptik dazu ausgebildet, das rote und mintgrün-weiße Licht derart zu mischen bzw. zu überlagern, dass von der Beleuchtungsvorrichtung weißes Licht emittiert wird.

Bei dem mintgrün-weißem Licht handelt es sich insbesondere um Licht aus folgendem Farbortbereich im CIE-Normalfarbsystem: 0,26 ≤ X ≤ 0,43 und 0,26 ≤ Y ≤ 0,53.

Das mintgrün-weiße Licht kann insbesondere von einem blaues Licht abstrahlenden Halbleiterchip erzeugt werden, der einen Leuchtstoff umfasst, der einen Teil des blauen Lichts in gelb-grünes Licht konvertiert.

Dadurch dass das optische Element vorzugsweise Strahlung in einem Winkelbereich von mehr als 70° zur Senkrechten der aktiven Flächen der Halbleiterchips emittiert, trifft die emittierte Strahlung gezielt auf die reflektierende Wand bzw. den reflektierenden Boden. Das auftreffende Licht wird von dem reflektierenden Boden bzw. der reflektierenden Wand vorzugsweise diffus gestreut. Damit kann eine effiziente und homogene Ausleuchtung erwirkt werden. Da die Beleuchtungsvorrichtung nur eine geringe Anzahl von vorzugsweise gleichartigen Komponenten (Halbleiterchips, optisches Element) aufweist, ist sie besonders einfach aufgebaut und kostengünstig.
Im Folgenden werden die optische Anordnung und die Beleuchtungsvorrichtung an Hand von Ausführungsbeispielen und den dazugehörigen Figuren näher erläutert.
- Die Figur 1A: zeigt eine Seitenansicht beispielhaften und nicht zur beanspruchten Erfindung gehörenden optischen Anordnung,
- Die Figur 1B: zeigt eine Draufsicht auf die optische Anordnung aus Figur 1A,
- Die Figur 2A: zeigt eine Seitenansicht einer optischen Anordnung gemäß eines weiteren nicht zur beanspruchten Erfindung gehörenden erläuternden Beispiels,
- Die Figur 2B: zeigt eine Draufsicht auf die optische Anordnung aus Figur 2A,
- Die Figur 3A: zeigt eine Seitenansicht einer optischen Anordnung gemäß eines Ausführungsbeispiels,
- Die Figur 3B: zeigt eine Draufsicht auf die optische Anordnung aus Figur 3A,
- Die Figur 4A: zeigt eine Seitenansicht einer optischen Anordnung gemäß eines weiteren erläuternden und nicht zur beanspruchten Erfindung gehörenden Beispiels,
- Die Figur 4B: zeigt eine Draufsicht auf die optische Anordnung aus Figur 4A,
- Die Figur 5A: zeigt eine Seitenansicht beispielhaften
- Die Figur 5B: Beleuchtungsvorrichtung, zeigt eine Draufsicht auf die Beleuchtungsvorrichtung aus Figur 5A,
- Die Figur 6A: zeigt eine Seitenansicht einer Beleuchtungsvorrichtung gemäß eines weiteren Ausführungsbeispiels,
- Die Figur 6B: zeigt eine Draufsicht auf die Beleuchtungsvorrichtung aus Figur 6A,
- Die Figur 7A: zeigt eine Seitenansicht einer beispielhaften Beleuchtungsvorrichtung,

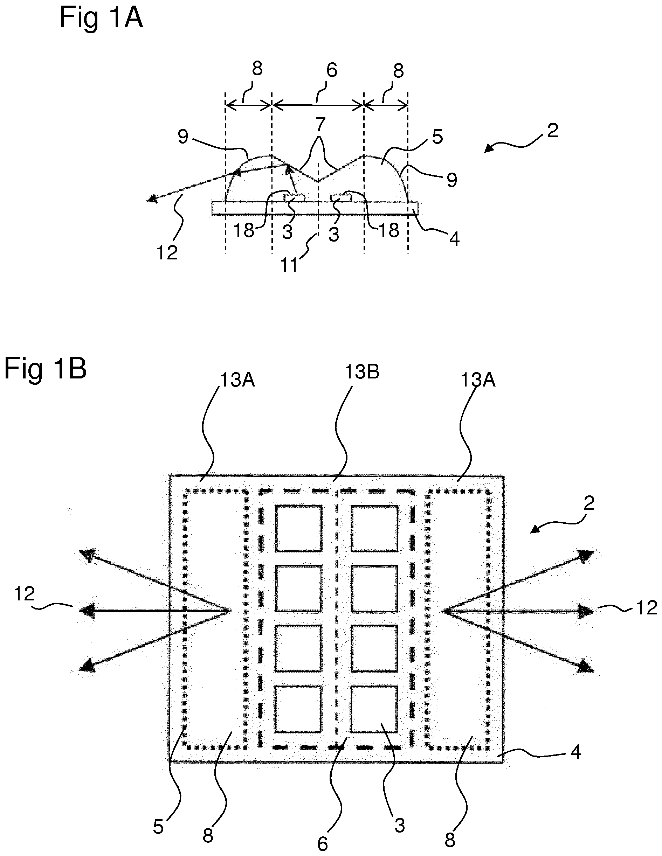

- Die Figur 7B: zeigt eine Draufsicht auf die Beleuchtungsvorrichtung aus Figur 7A.
Gleiche, gleichartige oder gleich wirkende Elemente sind in den Figuren mit den gleichen Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder für eine bessere Verständlichkeit übertrieben groß dargestellt sein.
Die optische Anordnung 2 umfasst einen Träger 4 sowie acht Halbleiterchips 3 (siehe Figur 1B). Die optische Anordnung 2 kann auch mehr oder weniger als acht Halbleiterchips 3 umfassen, beispielsweise vier oder 10 Halbleiterchips 3. Die Halbleiterchips 3 sind auf dem Träger 4 angeordnet. Der Träger 4 dient zur mechanischen Stabilisierung der Halbleiterchips 3.
Die Halbleiterchips 3 weisen jeweils eine aktive Fläche (nicht explizit dargestellt) zur Abstrahlung von elektromagnetischer Strahlung auf. Vorzugsweise strahlen die Halbleiterchips 3 farbiges Licht ab. Beispielsweise kann ein Teil der Halbleiterchips 3 rotes Licht abstrahlen und ein weiterer Teil der Halbleiterchips 3 mintgrün-weißes Licht.
Die Halbleiterchips 3 sind nicht willkürlich auf dem Träger 4 angebracht. Vielmehr sind die Halbleiterchips 3 strukturiert bzw. in einer bestimmten Struktur auf dem Träger 4 angebracht. In dem vorliegenden Beispiel sind die Halbleiterchips in Form eines Rechtecks auf dem Träger 4 angeordnet bzw. strukturiert (siehe Figur 1B). Innerhalb des Rechtecks weisen die Halbleiterchips 3 gleiche Abstände zueinander auf. Innerhalb des Rechtecks sind die Halbleiterchips 3 regelmäßig angeordnet.
Durch diese strukturierte Anordnung der Halbleiterchips 3 ist ein erster Bereich 13A des Trägers 4 (siehe Figur 1B) frei von Halbleiterchips 3. In einem zweiten Bereich 13B des Trägers 4 sind dafür alle Halbleiterchips 3 in Form des Rechtecks angeordnet bzw. angehäuft. Insgesamt sind die Halbleiterchips 3 damit ungleichmäßig über den Träger 4 bzw. in der Anordnung 2 verteilt.

Die optische Anordnung 2 weist ferner ein optisches Element 5, beispielsweise eine Linse, auf. Das optische Element 5 dient dazu die von den Halbleiterchips 3 emittierte Strahlung umzulenken. Das optische Element 5 ist den Halbleiterchips 3 in Abstrahlungsrichtung nachgeordnet. Zwischen dem optischen Element 5 und den Halbleiterchips 3 ist kein Abstand oder Luftspalt vorhanden. Vielmehr sind die Halbleiterchips 3 in das optische Element 5 eingebracht bzw. eingebettet. Beispielsweise sind die Halleiterchips 3 in eine Ausnehmung des optischen Elements 5 eingebettet (nicht explizit dargestellt). Das optische Element 5 ist vorzugsweise eine Primärlinse.

Das optische Element 5 weist eine Strahlungseintrittfläche 18 auf. An der Strahlungseintrittsfläche 18 tritt die von den Halbleiterchips 3 emittierte Strahlung in das optische Element 5 ein.

Das optische Element 5 ist einstückig ausgebildet. Das optische Element 5 weist in diesem Ausführungsbeispiel ein erstes Segment 6 und zwei zweite Segmente 8 auf. Die beiden zweiten Segmente 8 sind in Richtung der lateralen Haupterstreckungsrichtung der Anordnung 2 dem ersten Segment 6 nachgeordnet. Vorliegend sind die zweiten Segmente 8 also links und rechts von dem ersten Segment 6 angeordnet.

Die Segmente 6, 8 weisen jeweils einen rechteckigen Querschnitt auf. Das erste Segment 6 weist eine größere Breite bzw. laterale Ausdehnung auf, als eines der zweiten Segmente 8. Das erste Segment 6 ist in einem Bereich von -60° bis +60° zu einer Senkrechten der aktiven Flächen der Halbleiterchips 3 ausgebildet.

Das optische Element 5 weist eine symmetrische Form auf. Das optische Element 5 ist insbesondere rotationssymmetrisch aufgebaut. Das optische Element 5 ist symmetrisch bezüglich einer Symmetrieebene 11. Die Symmetrieebene 11 erstreckt sich in vertikaler Richtung durch das optische Element 5 und insbesondere durch das erste Segment 6.

Die Halbleiterchips 3 sind alle innerhalb des ersten Segments 6 angeordnet bzw. gruppiert. Die Halbleiterchips 3 sind insbesondere an einer dem Träger 4 zugewandten Unterseite des ersten Segments 6 angeordnet. Die Halbleiterchips 3 sind um die Symmetrieebene 11 herum angeordnet. Die Halbleiterchips 3 erstrecken sich in regelmäßigen Abständen zueinander vollständig über den Bereich des ersten Segments 6. Mit anderen Worten, das erste Segment 6, insbesondere der unter dem ersten Segment 6 angeordnete zweite Bereich 13B des Trägers 4, ist vollständig oder annähernd vollständig von den Halbleiterchips 3 bedeckt. Die zweiten Segmente 6 sind frei von den Halbleiterchips 3. Die Halbleiterchips 3 sind folglich eindeutig dem ersten Segment 6 des optischen Elements 5 zugeordnet.

Der erste Bereich 6 weist eine Grenzfläche 7 auf und der zweite Bereich 7 weist eine Grenzfläche 9 auf. Die Grenzflächen 7, 9 bilden Auskoppelflächen des optischen Elements 5 und stellen einen Übergang zwischen dem optischen Element 5 und der Umgebungsluft dar. Alternativ kann dem optischen Element 5 und insbesondere der Grenzfläche 9 des zweiten Segments 8 auch noch ein Konversionselement nachgeordnet sein (nicht explizit dargestellt), so dass in diesem Fall die Grenzfläche 9 des zweiten Segments 8 einen Übergang zwischen dem optischen Element 5 und dem Konversionselement darstellt.

Die Grenzfläche 7 des ersten Segments 6 ist gegenüberliegend zur der Strahlungseintrittsfläche 18 angeordnet. Das heißt die gesamte oder zumindest annähernd die gesamte von den Halbleiterchips 3 emittierte Strahlung trifft direkt auf die Grenzfläche 7 des ersten Segments 6 und trifft insbesondere erst nach einer Umlenkung auf die Grenzfläche 9 des zweiten Segments 8 (siehe eingezeichneten Strahlengang in Figur 1A).

Die Grenzfläche 7 des ersten Segments 6 ist totalreflektierend ausgebildet. Mit anderen Worten, die durch die Strahlungseintrittsfläche 18 in das optische Element 5 eintretende Strahlung oder zumindest ein Großteil davon wird von der Grenzfläche 7 des ersten Segments 6 auf die Grenzfläche 9 des zweiten Segments 8 totalreflektiert. Von der Grenzfläche 9 des zweiten Segments 8 wird die Strahlung dann in einen Winkelbereich von größer oder gleich 70° zu einer Senkrechten der aktiven Flächen der Halbleiterchips 3 gebrochen, wie aus Figur 1A ersichtlich ist. Das heißt, die von den Halbleiterchips 3 emittierte Strahlung wird in einem Winkel von 70° oder mehr aus dem optischen Element 5 ausgekoppelt.

Durch die besondere Ausgestaltung der Segmente 6, 8 und die Anordnung der Halbleiterchips 3 erfolgt die Abstrahlung in zwei einander gegenüberliegende Vorzugsrichtungen 12, hier in Richtung der lateralen Haupterstreckungsrichtung der Anordnung 2. Der Übersichtlichkeit halber ist in der Figur 1A jedoch nur eine Abstrahlung entlang einer Vorzugsrichtung dargestellt.

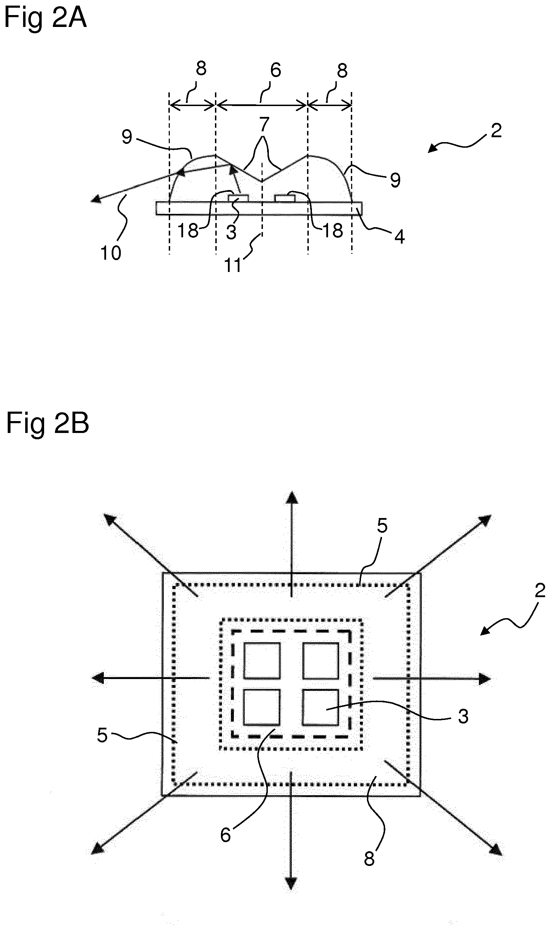

Die Figur 2A zeigt eine Seitenansicht einer optischen Anordnung 2 gemäß eines weiteren nicht zur Erfindung gehörenden erläuternden Beispiels. In Bezug auf die allgemeinen Merkmale der optischen Anordnung 2 wird dabei weitgehend auf die Beschreibung zu den Figuren 1A und 1B verwiesen.
Im Unterschied zu der in den Figuren 1A und 1B dargestellten Anordnung 2 weist das optische Element 5 hier ein erstes Segment 6 und nur ein zweites Segment 8 auf. Das zweite Segment 8 ist um das erste Segment 6 herum angeordnet (siehe Figur 2B). Das zweite Segment 8 umgibt das erste Segment 6 vollständig d.h. an allen Seiten des ersten Segments 6.
Das erste Segment 6 weist einen quadratischen Querschnitt auf. Auch das zweite Segment 8 weist einen quadratischen Querschnitt auf, nur weist das zweite Segment 8 eine von dem ersten Segment 6 gebildete Ausnehmung auf, wie der Figur 2B zu entnehmen ist. Die Halbleiterchips 3 sind um die Symmetrieebene 11 des optischen Elements 5 herum innerhalb des ersten Segments 6 angeordnet. Die Halbleiterchips 3 sind in diesem Ausführungsbeispiel in Form eines Quadrats auf dem Träger 4 und in dem ersten Segment 6 gruppiert. Die Strukturierung der Halbleiterchips 3 erfolgt folglich in einer Form, die durch den Querschnitt des ersten Segments 6 vorgegeben ist. Die Halbleiterchips 3 erstrecken sich in regelmäßigen Abständen zueinander vollständig über den Bereich des ersten Segments 6. Das zweite Segment 8 ist wiederum völlig frei von den Halbleiterchips 3.
Durch die besondere Ausgestaltung der Segmente 6, 8 und die Anordnung der Halbleiterchips 3 ist die von der optischen Anordnung 2 abgestrahlte Strahlung in dem vorliegenden Beispiel isotrop, also richtungsunabhängig (siehe Pfeile in der Figur 2B).

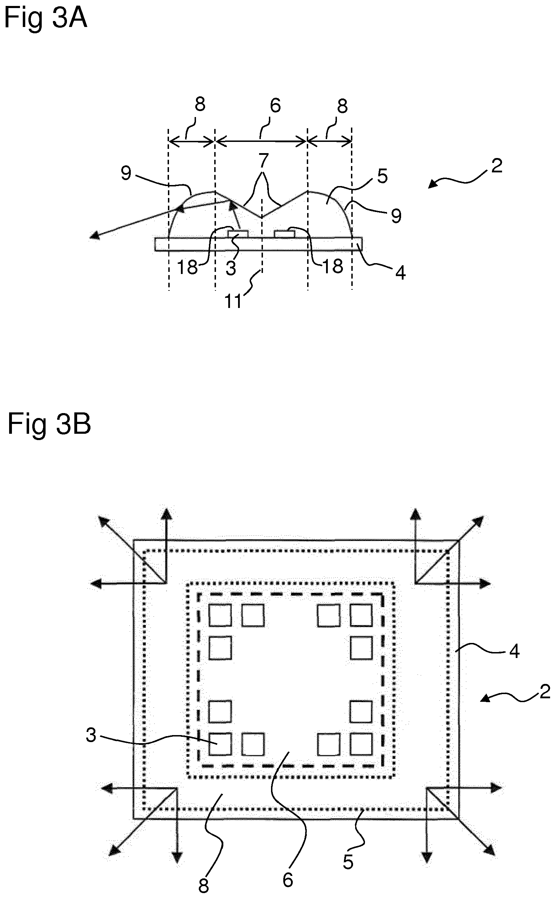

Die Figur 3A zeigt eine Seitenansicht einer optischen Anordnung 2 gemäß eines zur Erfindung gehörenden Ausführungsbeispiels.
In Bezug auf die allgemeinen Merkmale der optischen Anordnung 2 wird dabei weitgehend auf die Beschreibung zu den Figuren 1A und 1B verwiesen.
Im Unterschied zu der in den Figuren 1A und 1B dargestellten Anordnung 2 weist das optische Element 5 ein erstes Segment 6 und nur ein zweites Segment 8 auf. Das zweite Segment 8 ist wie bei dem in Figur 2B dargestellten optischen Element 5, um das erste Segment 6 herum angeordnet (siehe Figur 3B).
Das erste Segment 6 weist einen quadratischen Querschnitt auf. Das erste Segment 6 weist einen größeren Querschnitt auf, als das erste Segment 6 der in den Figuren 2A und 2B dargestellten optischen Anordnung 2. Das zweite Segment 8 weist einen quadratischen Querschnitt auf, jedoch weist das zweite Segment 8 eine von dem ersten Segment 6 gebildete Ausnehmung auf, wie der Figur 3B zu entnehmen ist.
Die Halbleiterchips 3 sind wiederum um die Symmetrieebene 11 des optischen Elements 5 herum innerhalb des ersten Segments 6 auf dem Träger 4 angeordnet. Jedoch sind die Halbleiterchips 3 anders als in den vorangegangen Ausführungsbeispielen nicht in Form einer zusammenhängenden Gruppe, sondern in Form von vier zusammenhängenden Gruppen angeordnet bzw. strukturiert (siehe Figur 3B). Die Halbleiterchips 3 sind an einem an das zweite Segment 8 angrenzenden Randbereich des ersten Segments 6 in den vier Gruppen angeordnet. Die Halbleiterchips 3 sind insbesondere an den in dem Querschnitt aus Figur 3 erkennbaren Ecken des ersten Segments 6 angeordnet.
Die Abstände der Halbleiterchips 3 innerhalb einer Gruppe sind dabei gleich. In einem alternativen Ausführungsbeispiel (nicht explizit dargestellt) können die Abstände der Halbleiterchips 3 innerhalb einer Gruppe aber auch unterschiedlich sein, wenn das optische Element 5 dies erfordert.
Die Abstände zwischen den Halbleiterchips 3 unterschiedlicher Gruppen sind größer als die Abstände der Halbleiterchips 3 innerhalb einer Gruppe. Insgesamt sind die Halbleiterchips 3 ungleichmäßig in dem ersten Segment 6 verteilt. Es gibt also Bereiche, insbesondere der Mittelbereich, des ersten Segments 6, die frei on Halbleiterchips 3 sind. Auch das zweite Segment 8 bzw. der unter dem zweiten Segment 8 liegende Bereich 13A des Trägers 4 (erster Bereich 13A des Trägers 4) ist völlig frei von den Halbleiterchips 3.
Durch die besondere Ausgestaltung der Segmente 6, 8 und die Anordnung der Halbleiterchips 3 ist die optische Anordnung 2 zur homogenen Ausleuchtung einer eckigen Fläche, hier also eines Quadrats, geeignet (siehe Pfeile in der Figur 3B). Das optische Element 2 emittiert die Strahlung vorzugsweise in Verlängerung der Ecken des Trägers 4 (siehe Figur 3B). Die Ecken werden somit besonders effektiv ausgeleuchtet.

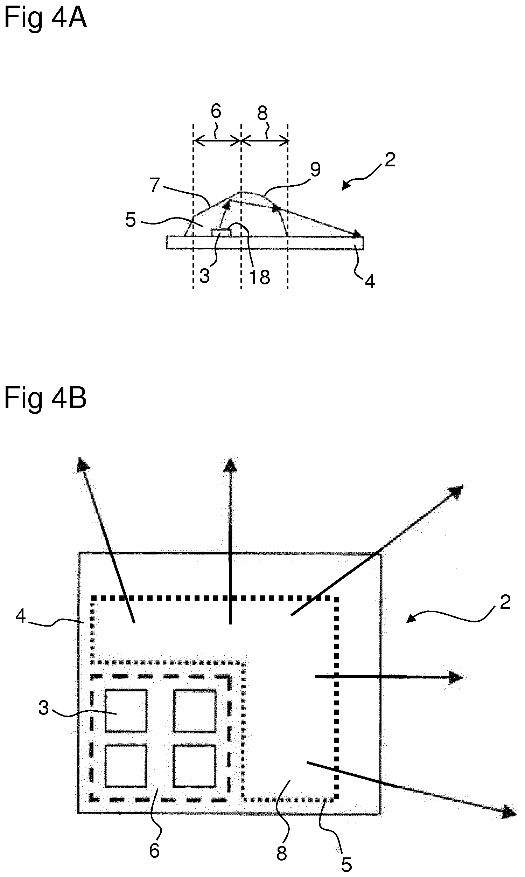

Die Figur 4A zeigt eine Seitenansicht einer optischen Anordnung 2 gemäß eines weiteren nicht zur beanspruchten Erfindung gehörenden erläuternden Beispiels. In Bezug auf die allgemeinen Merkmale der optischen Anordnung 2 wird dabei weitgehend auf die Beschreibung zu den Figuren 1A und 1B verwiesen.

Im Unterschied zu der in den Figuren 1A und 1B dargestellten Anordnung 2 weist das optische Element 5 ein erstes Segment 6 und nur ein zweites Segment 8 auf. Ferner ist das optische Element 5 anders als in allen vorangegangen nicht zur Erfindung gehörenden erläuternden Beispielen und der Erfindung gehörenden Ausführungsbeispielen nicht symmetrisch aufgebaut. Das erste Segment 6 ist in einem Randbereich des optischen Elements 5 angeordnet. Das erste Segment 6 bildet mit anderen Worten einen Randbereich des optischen Elements 5. Angrenzend an das erste Segment 6 ist das zweite Segment 8 angeordnet. Das zweite Segment 8 grenzt an zwei Seiten an das erste Segment 6 an.
Das erste Segment 6 weist einen quadratischen Querschnitt auf. Das zweite Segment 8 weist einen Querschnitt auf, welcher sind aus zwei Rechtecken zusammensetzt. Die Halbleiterchips 3 sind in Form eines Quadrats auf dem Träger 4 und innerhalb des ersten Segments 6 angeordnet. Die Halbleiterchips 3 erstrecken sich in regelmäßigen Abständen zueinander vollständig über den Bereich des ersten Segments 6. Das zweite Segment 8 und insbesondere der unter dem zweiten Segment 8 liegende Bereich des Trägers 4 ist wiederum völlig frei von den Halbleiterchips 3.
Durch die besondere Ausgestaltung der Segmente 6, 8 und die Anordnung der Halbleiterchips 3 strahlt die optische Anordnung 2 einen Großteil, vorzugsweise 80% oder mehr, der Strahlung in einem Winkelbereich von größer oder gleich 90°, beispielsweise 95°, zur Senkrechten der aktiven Flächen der Halbleiterchips 3 ab, wie in der Figur 4A ersichtlich ist. Dadurch dass das erste Segment 6 in einem Randbereich des optischen Elements 5 angeordnet ist, strahlt die Anordnung 2 die Strahlung nur in zwei Richtungen, insbesondere den von dem ersten Segment 6 abgewandten Richtungen, in den Raum ab (siehe Pfeile in der Figur 4B).

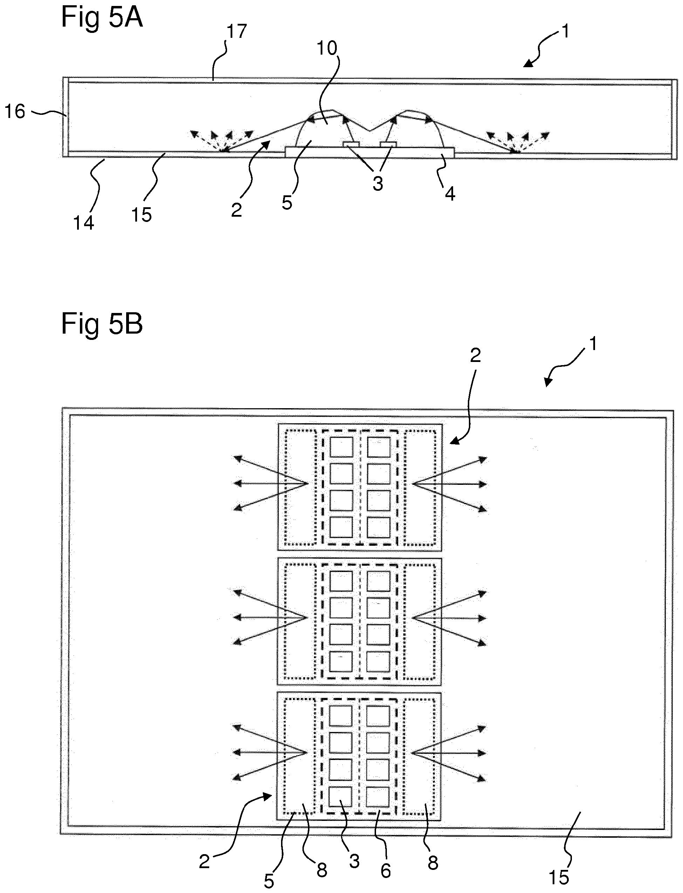

Die Figur 5A zeigt eine Seitenansicht einer Beleuchtungsvorrichtung 1. Die Beleuchtungsvorrichtung 1 strahlt weißes Licht ab. Die Beleuchtungsvorrichtung 1 weist drei optische Anordnungen 2 gemäß dem in den Figuren 1A und 1B dargestellten Beispiel auf. Die Beleuchtungsvorrichtung 1 kann beispielsweise aber auch nur eine der in den Figuren 1A und 1B gezeigten Anordnungen 2 oder eine Kombination aus verschiedenen in den Figuren 1A bis 4A gezeigten Anordnungen 2 aufweisen.
Die Beleuchtungsvorrichtung 1 weist ferner ein Gehäuse 14 auf, in dem die Anordnungen 2 angeordnet sind. Das Gehäuse 14 weist einen rechteckigen Querschnitt auf (siehe Figur 5B). Das Gehäuse 14 kann aber auch jede andere geeignete Form, beispielsweise einen quadratischen oder einen runden Querschnitt, aufweisen. Das Gehäuse 14 weist einen Boden 15 und einen Wand 16 auf. Der Boden 15 und wie Wand 16 sind reflektierend ausgebildet, z.B. oberflächenstrukturiert. Der Boden 15 und die Wand 16 reflektieren und/oder streuen die auf sie auftreffende von den Anordnungen 2 emittierte Strahlung diffus, d.h. ungerichtet bzw. in alle Richtungen. Die Reflektivität des Bodens 15 und der Wand 16 ist vorzugsweise größer oder gleich 90%, besonders bevorzugt größer oder gleich 95%.
Die Anordnungen 2 sind auf dem Boden 15 angebracht bzw. befestigt, beispielsweise angeklebt oder angelötet. Insbesondere ist der jeweilige Träger 4 der Anordnung 2 an dem Boden 15 befestigt. Die optischen Anordnungen 2 sind in Form eines um den Mittelbereich des Bodens 15 angeordneten Streifens oder Rechtecks auf dem Boden 15 befestigt. Die Anordnungen 2 erstrecken sich über die komplette Tiefe bzw. horizontale Ausdehnung der Beleuchtungsvorrichtung 1. Dahingegen erstrecken sich die Anordnungen 2 lediglich über einen Teil der Breite bzw. lateralen Ausdehnung der Beleuchtungsvorrichtung 1. Beispielsweise decken die Anordnungen 2 nur ca. 30% der Breite der Beleuchtungsvorrichtung 1 bzw. des Bodens 15 ab. Insgesamt bedecken die Anordnungen zu weniger als 50%, vorzugsweise weniger als 30%, den reflektierenden Boden 15. Die Anordnungen 2 grenzen in horizontaler Richtung aneinander an.
Da nur ein Teil des Bodens 15 mit Anordnungen 2 bedeckt ist, sind die Anordnungen 2 nur ungleichmäßig über den Boden 15 verteilt. Insbesondere sind die in den Anordnungen 2 verbauten Halbleiterchips 3 nur ungleichmäßig über den Boden 15 hinweg verteilt. Insgesamt ist ein Großteil des Bodens 15, im Folgenden ein erster Bereich des Bodens 15, frei von Anordnungen 2 und damit auch frei von Halbleiterchips 3. Im vorliegenden Beispiel sind nur etwa 10% des Bodens 15 mit Halbleiterchips 3 bestückt. In diesen 10% des Bodens 15, im folgenden zweiter Bereich des Bodens 15, treten die Halbleiterchips 3 wie in Zusammenhang mit den Figuren 1A bis 4B beschrieben, gehäuft bzw. strukturiert auf.
Die Beleuchtungsvorrichtung 1 weist ferner eine Auskoppelfläche 17 auf, an dem die Strahlung von der Beleuchtungsvorrichtung 1 an die Umgebung abgegeben wird. In Richtung der Auskoppelfläche 17 kann die Beleuchtungsvorrichtung 1 auch noch eine Mischoptik oder Lichtformungsoptik, beispielsweise sich kreuzende Prismenfolien, Mikrolinsen oder Mikroprismen, aufweisen (nicht explizit dargestellt). Die Mischoptik ist dazu ausgebildet und angeordnet, das von den Halbleiterchips 3 in verschiedenen Spektralbereichen emittierte Licht in weißes Licht umzuwandeln.
Die Anordnungen 2 emittieren in dem vorliegenden Ausführungsbeispiel die Strahlung entlang zweier gegenüberliegender Vorzugsrichtungen und insbesondere entlang der lateralen Haupterstreckungsrichtung der jeweiligen Anordnung 2 (siehe Figur 5B). Die von den Anordnungen 2 emittierte Strahlung trifft auf den reflektierenden Boden 15 und/oder die reflektierende Wand 16 auf. Der Boden 15 und die Wand 16 reflektieren diese Strahlung diffus bzw. in alle Richtungen. Die diffuse Strahlung wird an der Auskoppelfläche 17 an die Umgebung abgegeben. Somit wird durch eine geringe Zahl von ungleichmäßig verteilten Halbleiterchips 3 eine effektive und homogene Ausleuchtung von Flächen durch die Beleuchtungsvorrichtung 1 bewirkt.

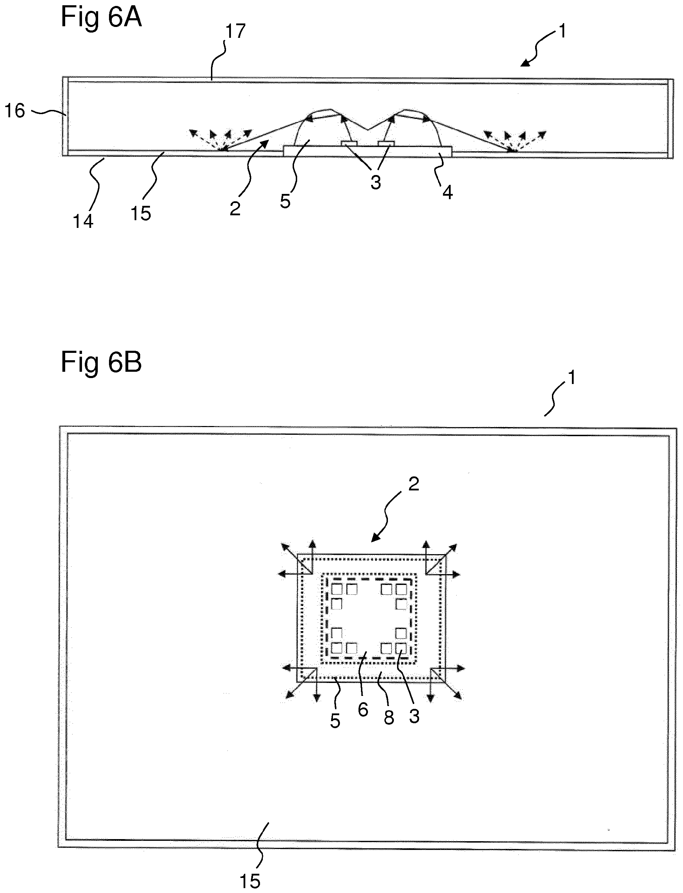

Die Figur 6A zeigt eine Seitenansicht einer erfindungsgemäßen Beleuchtungsvorrichtung 1. In Bezug auf die allgemeinen Merkmale der Beleuchtungsvorrichtung 1 wird dabei weitgehend auf die Beschreibung zu den Figuren 5A und 5B verwiesen.
Die Beleuchtungsvorrichtung 1 weist im Gegensatz zu der in den Figuren 5A und 5B gezeigten Beleuchtungsvorrichtung 1 eine optische Anordnung 2 gemäß dem in den Figuren 3A und 3B dargestellten Ausführungsbeispiel auf. Selbstverständlich können aber auch mehrere solcher Anordnungen 2 auf dem Boden 15 aufgebracht sein. Beispielsweise kann auch noch jeweils eine Anordnung 2 gemäß dem in den Figuren 4A und 4B gezeigten Ausführungsbeispiel in den Eckbereichen des Bodens 15 angebracht sein (nicht explizit dargestellt).

Die gezeigte Anordnung 2 ist, wie oben beschrieben, besonders gut dazu geeignet eine eckige Fläche auszuleuchten. Die Anordnung 2 ist auf einer Mitte des Bodens 15 aufgebracht. Der Rest des Bodens 15 ist frei von Anordnungen 2 und damit auch frei von Halbleiterchips 3. Insbesondere ist in diesem Ausführungsbeispiel nur eine sehr geringe Anzahl von Halbleiterchips 3 in ungleichmäßiger Weise auf dem Boden 15 angebracht bzw. über den Boden 15 verteilt. Wie in Zusammenhang mit den Figuren 3A und 3B beschrieben, sind die Halbleiterchips 3 in Form von vier zusammenhängenden Gruppen innerhalb des ersten Segments 6 des optischen Elements 5 auf dem Träger 4 der Anordnung 2 und somit auf dem reflektierenden Boden 15 angeordnet. Ein Großteil des Bodens 15, vorliegend mindestens 90% oder mehr, ist damit völlig frei von Halbleiterchips. Die Halbleiterchips 3 sind in anderen Worten nur in einem kleinen Bereich des Bodens 15, dem vorher beschriebenen zweiten Bereich des Bodens 15, gruppiert bzw. strukturiert angeordnet, so dass eine ungleichmäßige Verteilung der Halbleiterchips 3 über den Boden 15 vorliegt.
Die von der Anordnung 2 emittierte Strahlung trifft vorzugsweise in Richtung der Ecken des Gehäuses 14 (siehe Figur 6B) auf den reflektierenden Boden 15 und/oder die reflektierende Wand 16 auf, wird von diesen diffus gestreut und an der Auskoppelfläche 17 an die Umgebung abgegeben. Somit wird durch eine geringe Zahl von ungleichmäßig verteilten Halbleiterchips 3 eine effektive und homogene Ausleuchtung von eckigen Flächen durch die Beleuchtungsvorrichtung 1 bewirkt.

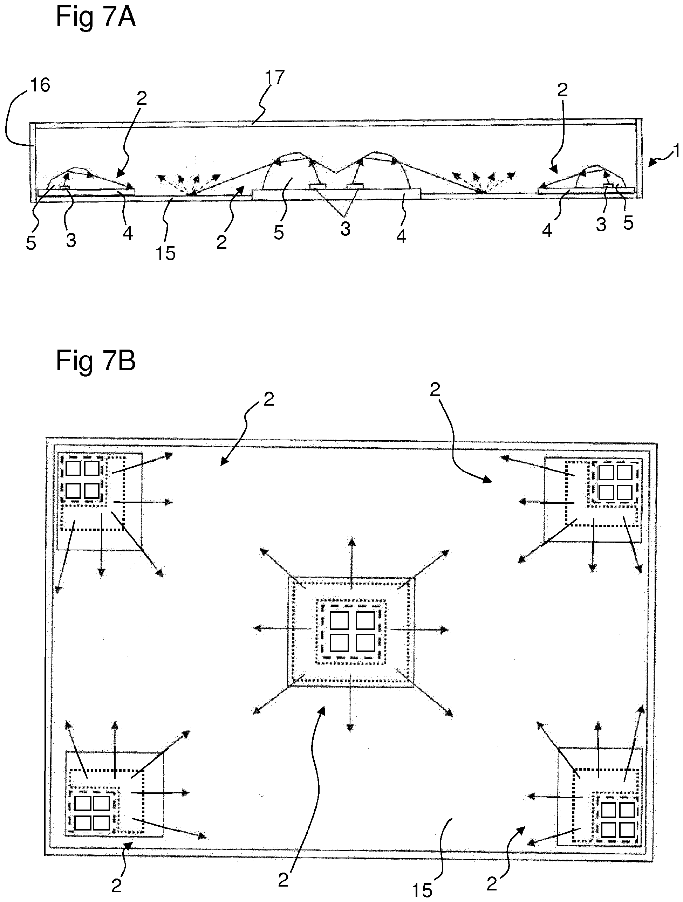

Die Figur 7A zeigt eine Seitenansicht einer weiteren nicht zu Erfindung gehörenden beispielhaften Beleuchtungsvorrichtung 1. In Bezug auf die allgemeinen Merkmale der Beleuchtungsvorrichtung 1 wird dabei weitgehend auf die Beschreibung zu den Figuren 5A und 5B verwiesen.
Die Beleuchtungsvorrichtung 1 weist im Gegensatz zu der in den Figuren 5A und 5B gezeigten Beleuchtungsvorrichtung 1 eine optische Anordnung 2 gemäß dem in den Figuren 2A und 2B dargestellten Beispiel auf. Diese strahlt die Strahlung isotrop ab. Ferner weist die Beleuchtungsvorrichtung 1 vier optische Anordnungen 2 gemäß dem in den Figuren 4A und 4B dargestellten Beispiel auf.
Die Anordnung 2 aus den Figuren 2A und 2B ist in der Mitte des Bodens 15 angeordnet. Jeweils eine Anordnung 2 aus den Figuren 4A und 4B ist an den Ecken bzw. in den Eckbereichen des Bodens 15 angebracht. Somit ist wiederum nur ein Teil des Bodens 15 mit Anordnungen 2 und damit Halbleiterchips 3 bedeckt. Insgesamt sind maximal 20% des Bodens mit in ungleichmäßigen Abständen angeordneten Halbleiterchips 3 bedeckt. Zu der Gruppierung bzw. Strukturierung der Halbleiterchips 3 wird an dieser Stelle auf die Ausführungen zu den Figuren 2A, 2B, 4A und 4B verwiesen.
Die von der Anordnung 2 aus den Figuren 2A und 2B emittierte Strahlung trifft vorzugsweise in allen Richtungen auf den reflektierenden Boden 15 auf und wird von diesem diffus gestreut (siehe Figur 7B). Die von der jeweiligen Anordnung 2 aus den Figuren 4A und 4B emittierte Strahlung trifft vorzugsweise in einem Winkeln von 90° oder mehr, beispielsweise 95° oder 97°, zu den aktiven Flächen der Halbleiterchips 3 der jeweiligen Anordnung 2 auf den reflektierenden Boden 15 auf und wird von diesem diffus, d.h. in mehrere Richtungen, gestreut (siehe Figur 7B). Dabei sind die Anordnungen 2 aus den Figuren 4A und 4B so auf dem Boden 15 angebracht, dass sie die Strahlung in Richtung der Mitte des Bodens 15 und von den Ecken des Gehäuses 14 weg emittieren. Die diffus reflektierte Strahlung kann wiederum von der Wand 16 reflektiert werden. An der Auskoppelfläche 17 wird die diffus gestreute Strahlung an die Umgebung abgegeben. Somit wird durch eine geringe Zahl von ungleichmäßig verteilten Halbleiterchips 3 eine homogene und effektive Ausleuchtung von Flächen durch die Beleuchtungsvorrichtung 1 bewirkt.
Die Erfindung ist nicht durch die Beschreibung anhand der Ausführungsbeispiele auf diese beschränkt, sondern wird durch die untenstehenden Ansprüche bestimmt.

## Patentansprüche

1. Optische Anordnung (2) zur Abstrahlung elektromagnetischer Strahlung, aufweisend:
- einen Träger (4),
- eine Mehrzahl von Halbleiterchips (3), wobei die Halbleiterchips (3) auf dem Träger (4) angeordnet sind, und wobei die Halbleiterchips (3) jeweils eine aktive Zone zur Erzeugung von elektromagnetischer Strahlung aufweisen,
- wenigstens ein optisches Element (5), wobei das optische Element (5) den Halbleiterchips (3) in Abstrahlungsrichtung nachgeordnet ist, und wobei das optische Element (5) zur Umlenkung der von den Halbleiterchips (3) erzeugten Strahlung ausgebildet ist, so dass ein Großteil der Strahlung in einen Winkel von größer oder gleich 70° zu einer Senkrechten der aktiven Flächen der Halbleiterchips (3) von der optischen Anordnung (2) abgestrahlt wird,
wobei die Halbleiterchips (3) derart angeordnet sind, dass eine ungleichmäßige Verteilung der Halbleiterchips (3) auf dem Träger (4) und damit eine ungleichmäßige Zuordnung der Halbleiterchips (3) zu einzelnen Segmenten (6, 8) des optischen Elements (5) erreicht ist,
**dadurch gekennzeichnet dass**,
die Halbleiterchips (3) derart auf dem Träger (4) angeordnet sind und das optische Element (5) derart ausgebildet und angeordnet ist, dass die optische Anordnung (2) zur homogenen Ausleuchtung einer eckigen Fläche geeignet ist, wobei
- ein erstes Segment (6) des optischen Elements (5) vollständig von einem zweiten Segment (8) des optischen Elements (5) umgeben ist,
- die Halbleiterchips (3) um eine Symmetrieebene (11) des optischen Elements (5) herum an einem an das zweite Segment (8) angrenzenden Randbereich des ersten Segments (6) in Gruppen angeordnet sind, und
- der Träger (4) in einem Bereich zwischen den Gruppen frei von Halbleiterchips (3) ist.

2. Optische Anordnung (2) nach Anspruch 1,
wobei das optische Element (5) wenigstens eine Strahlungseintrittsfläche (18), eine Grenzfläche (7) des ersten Segments (6) und eine Grenzfläche (9) des zweiten Segments (8) aufweist, wobei die Grenzflächen (7, 9) so angeordnet und ausgebildet sind, dass ein Großteil der durch die Strahlungseintrittsfläche (18) in das optische Element (5) eintretenden Strahlung von der Grenzfläche (7) des ersten Segments (6) auf die Grenzfläche (9) des zweiten Segments (8) reflektiert wird, und von der Grenzfläche (9) des zweiten Segments (8) in den Winkelbereich von größer oder gleich 70° zur Senkrechten der aktiven Flächen der Halbleiterchips (3) gebrochen wird.

3. Optische Anordnung (2) nach Anspruch 1,
wobei das optische Element (5) die Halbleiterchips (3) vollständig umgibt, und wobei das optische Element (5) so ausgebildet ist, dass die Halbleiterchips (3) vollständig innerhalb des ersten Segments (6) angeordnet sind.

4. Optische Anordnung (2) nach einem der Ansprüche 1 bis 3,
wobei das erste Segment (6) in einem Bereich von -60° bis +60° zur Senkrechten der aktiven Flächen der Halbleiterchips (3) ausgebildet ist.

5. Optische Anordnung (2) nach einem der Ansprüche 2 bis 4,
wobei die Grenzfläche (7) des ersten Segments (6) gegenüberliegend zu der Strahlungseintrittsfläche (18) angeordnet ist.

6. Optische Anordnung (2) nach einem der Ansprüche 2 bis 5,
wobei das erste Segment (6) so angeordnet und ausgebildet ist, dass der Großteil der durch die Strahlungseintrittsfläche (18) eintretenden Strahlung von der Grenzfläche (7) des ersten Segments (6) totalreflektiert wird.

7. Optische Anordnung (2) nach einem der Ansprüche 1 bis 6,
wobei die Halbleiterchips (3) derart auf dem Träger (4) angeordnet sind, und wobei das optische Element (5) derart ausgebildet und angeordnet ist, dass die Abstrahlung der optischen Anordnung (2) in zwei einander gegenüberliegende Vorzugsrichtungen erfolgt.

8. Optische Anordnung (2) nach Anspruch 7,
wobei dem ersten Segment (6) in Richtung einer lateralen Haupterstreckungsrichtung der optischen Anordnung (2) das zweite Segment (8) nachgeordnet ist, und wobei die Halbleiterchips (3) um eine Symmetrieebene (11) des optischen Elements (5) herum innerhalb des ersten Segments (6) angeordnet sind.

9. Optische Anordnung (2) nach Anspruch 8,
wobei die Segmente (6, 8) jeweils einen rechteckigen Querschnitt aufweisen, und das optische Element (5) symmetrisch bezüglich der Symmetrieebene (11) ist.

10. Optische Anordnung (2) nach einem der Ansprüche 1 bis 6,
wobei die Halbleiterchips (3) derart auf dem Träger (4) angeordnet sind, und wobei das optische Element (5) derart ausgebildet und angeordnet ist, dass die von der optischen Anordnung (2) abgestrahlte Strahlung isotrop ist.

11. Optische Anordnung (2) nach Anspruch 10,
wobei das erste Segment (6) vollständig von dem zweiten Segment (8) umgeben ist, und wobei die Halbleiterchips (3) um eine Symmetrieebene (11) des optischen Elements (5) herum innerhalb des ersten Segments (6) angeordnet sind.

12. Optische Anordnung (2) nach einem der Ansprüche 1 bis 6,
wobei die Halbleiterchips (3) derart auf dem Träger (4) angeordnet sind, und wobei das optische Element (5) derart ausgebildet und angeordnet ist, dass ein Großteil der von der optischen Anordnung (2) abgestrahlten Strahlung in einem Winkelbereich von größer oder gleich 90° zur Senkrechten der aktiven Flächen der Halbleiterchips (3) abgestrahlt wird.

13. Optische Anordnung (2) nach Anspruch 12,
wobei das erste Segment (6) in einem Randbereich des optischen Elements (5) angeordnet ist, und wobei die Halbleiterchips (3) in einem Randbereich des Trägers (4) innerhalb des ersten Segments (6) angeordnet sind.

14. Beleuchtungsvorrichtung (1) zur Ausleuchtung von Flächen, aufweisend:
- wenigstens eine optische Anordnung (2) nach einem der vorigen Ansprüche,
- ein Gehäuse (14), wobei das Gehäuse (14) einen reflektierenden Boden (15) aufweist, wobei die optische Anordnung (2) auf dem reflektierenden Boden (15) angeordnet ist, wobei der reflektierende Boden (15) dazu ausgebildet ist, die von der optischen Anordnung (2) abgestrahlte Strahlung zu reflektieren, und wobei durch die ungleichmäßige Anordnung der Halbleiterchips (3) auf dem Träger (4) der optischen Anordnung (2) eine ungleichmäßige Verteilung der Halbleiterchips (3) über den reflektierenden Boden (15) des Gehäuses (14) erreicht wird.

## Claims

1. Optical arrangement (2) for emitting electromagnetic radiation, comprising:
- a carrier (4),
- a plurality of semiconductor chips (3), the semiconductor chips (3) being arranged on the carrier (4), and the semiconductor chips (3) each comprising an active zone for generating electromagnetic radiation,
- at least one optical element (5), the optical element (5) being arranged downstream of the semiconductor chips (3) in the direction of emission, and the optical element (5) being configured to deflect the radiation generated by the semiconductor chips (3), such that a major part of the radiation is emitted from the optical arrangement (2) at an angle of greater than or equal to 70° to a perpendicular of the active areas of the semiconductor chips (3),
the semiconductor chips (3) being arranged in such a way that a non-uniform distribution of the semiconductor chips (3) on the carrier (4) and thus a non-uniform assignment of semiconductor chips (3) to individual segments (6, 8) of the optical element (5) is achieved,
**characterized in that**,
the semiconductor chips (3) are arranged in such a way on the carrier (4) and the optical element (5) is configured and arranged in such a way that the optical arrangement (2) is suitable for homogeneous illumination of a polygonal area, wherein
- a first segment (6) of the optical element (5) is completely surrounded by a second segment (8) of the optical element (5),
- the semiconductor chips (3) are arranged in groups around a plane of symmetry (11) of the optical element (5) at a peripheral region of the first segment (6) adjoining the second segment (8), and
- the carrier (4) is free of semiconductor chips (3) in a region between the groups.

2. Optical arrangement (2) according to claim 1,
wherein the optical element (5) comprises at least one radiation entrance face (18), a boundary surface (7) of the first segment (6) and a boundary surface (9) of the second segment (8), wherein the boundary surfaces (7, 9) are arranged and configured in such a way that a major part of the radiation entering the optical element (5) through the radiation entrance face (18) is reflected by the boundary surface (7) of the first segment (6) onto the boundary surface (9) of the second segment (8), and refracted by the boundary surface (9) of the second segment (8) into the angular range of greater than or equal to 70° to the perpendicular of the active areas of the semiconductor chips (3) .

3. Optical arrangement (2) according to claim 1,
wherein the optical element (5) completely surrounds the semiconductor chips (3), and wherein the optical element (5) is configured such that the semiconductor chips (3) are arranged wholly within the first segment (6).

4. Optical arrangement (2) according to one of claims 1 to 3,
wherein the first segment (6) is configured in a range from - 60° to +60° to the perpendicular of the active areas of the semiconductor chips (3).

5. Optical arrangement (2) according to one of claims 2 to 4,
wherein the boundary surface (7) of the first segment (6) is arranged opposite the radiation entrance face (18).

6. Optical arrangement (2) according to one of claims 2 to 5,
wherein the first segment (6) is arranged and configured such that the major part of the radiation entering through the radiation entrance face (18) is totally reflected by the boundary surface (7) of the first segment (6).

7. Optical arrangement (2) according to one of claims 1 to 6,
wherein the semiconductor chips (3) are arranged in such a way on the carrier (4) and wherein the optical element (5) is configured and arranged in such a way that emission from the optical arrangement (2) proceeds in two mutually opposing preferential directions.

8. Optical arrangement (2) according to claim 7,
wherein the second segment (8) is arranged downstream of the first segment (6) in the direction of a lateral main direction of extension of the optical arrangement (2), and wherein the semiconductor chips (3) are arranged around a plane of symmetry (11) of the optical element (5) within the first segment (6).

9. Optical arrangement (2) according to claim 8,
wherein the segments (6, 8) each have a rectangular cross-section, and the optical element (5) is symmetrical relative to the plane of symmetry (11).

10. Optical arrangement (2) according to one of claims 1 to 6,
wherein the semiconductor chips (3) are arranged in such a way on the carrier (4) and wherein the optical element (5) is configured and arranged in such a way that the radiation emitted by the optical arrangement (2) is isotropic.

11. Optical arrangement (2) according to claim 10,
wherein the first segment (6) is completely surrounded by the second segment (8), and wherein the semiconductor chips (3) are arranged around a plane of symmetry (11) of the optical element (5) within the first segment (6).

12. Optical arrangement (2) according to one of claims 1 to 6,
wherein the semiconductor chips (3) are arranged in such a way on the carrier (4) and wherein the optical element (5) is configured and arranged in such a way that a major part of the radiation emitted by the optical arrangement (2) is emitted within an angular range of greater than or equal to 90° to the perpendicular of the active areas of the semiconductor chips (3).

13. Optical arrangement (2) according to claim 12,
wherein the first segment (6) is arranged in a peripheral region of the optical element (5), and wherein the semiconductor chips (3) are arranged in a peripheral region of the carrier (4) within the first segment (6).

14. Lighting device (1) for illuminating areas, comprising:
- at least one optical arrangement (2) according to one of the preceding claims,
- a package (14), wherein the package (14) comprises a reflective bottom (15), wherein the optical arrangement (2) is arranged on the reflective bottom (15), wherein the reflective bottom (15) is configured to reflect the radiation emitted by the optical arrangement (2), and wherein a non-uniform distribution of the semiconductor chips (3) over the reflective bottom (15) of the package (14) is achieved by the non-uniform arrangement of the semiconductor chips (3) on the carrier (4) of the optical arrangement (2).

## Revendications

1. Ensemble optique (2) destiné à émettre un rayonnement électromagnétique, présentant :
- un support (4),
- une pluralité de puces semi-conductrices (3), les puces semi-conductrices (3) étant disposées sur le support (4) et lesdites puces semi-conductrices (3) présentant chacune une zone active pour générer un rayonnement électromagnétique,
- au moins un élément optique (5), l'élément optique (5) étant disposé après les puces semi-conductrices (3) dans le sens d'émission, et ledit élément optique (5) étant conçu pour dévier le rayonnement généré par les puces semi-conductrices (3) de telle sorte qu'une grande partie du rayonnement est émise de l'ensemble optique (2) dans un angle supérieur ou égal à 70° par rapport à une perpendiculaire des surfaces actives desdites puces semi-conductrices (3),
les puces semi-conductrices (3) étant disposées de telle sorte qu'est obtenue une répartition irrégulière des puces semi-conductrices (3) sur le support (4) et, dès lors, une attribution irrégulière desdites puces semi-conductrices (3) aux différents segments (6, 8) de l'élément optique (5),
**caractérisé en ce que**
les puces semi-conductrices (3) sont disposées de telle manière sur le support (4), et l'élément optique (5) étant conçu et disposé de telle sorte que l'ensemble optique (2) est susceptible d'éclairer de manière homogène une surface angulaire,
- un premier segment (6) de l'élément optique (5) étant complètement entouré d'un deuxième segment (8) de l'élément optique (5),
- les puces semi-conductrices (3) étant, tout autour d'un plan de symétrie (11) de l'élément optique (5), disposées en groupes sur une zone périphérique du premier segment (6) attenante au deuxième segment (8), et
- le support (4) étant, dans une zone entre les groupes, exempt de puces semi-conductrices (3).

2. Ensemble optique (2) selon la revendication 1, l'élément optique (5) présentant au moins une surface d'entrée du rayonnement (18), une interface (7) du premier segment (6) et une interface (9) du deuxième segment (8), lesdites interfaces (7, 9) étant disposées et conçues de telle sorte qu'une grand partie du rayonnement qui pénètre dans l'élément optique (5) par la surface d'entrée de rayonnement (18) est réfléchie par l'interface (7) du premier segment (6) sur l'interface (9) du deuxième segment (8) et brisée par l'interface (9) du deuxième segment (8) vers la zone d'angle supérieure ou égale à 70° par rapport à la perpendiculaire des surfaces actives des puces semi-conductrices (3).

3. Ensemble optique (2) selon la revendication 1, l'élément optique (5) entourant entièrement les puces semi-conductrices (3) et l'élément optique (5) étant conçu de telle sorte que les puces semi-conductrices (3) sont entièrement disposées au sein du premier segment (6).

4. Ensemble optique (2) selon l'une quelconque des revendications 1 à 3, le premier segment (6) étant conçu dans une zone de -60° à +60° par rapport à la perpendiculaire des surfaces actives des puces semi-conductrices (3).

5. Ensemble optique (2) selon l'une quelconque des revendications 2 à 4, l'interface (7) du premier segment (6) étant disposée en face de la surface d'entrée du rayonnement (18).

6. Ensemble optique (2) selon l'une quelconque des revendications 2 à 5, le premier segment (6) étant disposé et conçu de telle sorte que la plupart du rayonnement entrant par la surface d'entrée du rayonnement (18) est totalement réfléchie par l'interface (7) du premier segment (6) .

7. Ensemble optique (2) selon l'une quelconque des revendications 1 à 6, les puces semi-conductrices (3) étant disposées sur le support (4) de telle sorte, et l'élément optique (5) étant conçu et disposé de telle sorte que l'émission de l'ensemble optique (2) s'effectue dans deux directions préférentielles opposées l'une à l'autre.

8. Ensemble optique (2) selon la revendication 7, le deuxième segment (8) étant disposé, dans un sens d'allongement principal latéral de l'ensemble optique (2), après le premier segment (6), et les puces semi-conductrices (3) étant disposées, tout autour d'un plan de symétrie (11) de l'élément optique (5), au sein du premier segment (6).

9. Ensemble optique (2) selon la revendication 8, les segments (6, 8) présentant chacun une section droite rectangulaire et l'élément optique (5) étant symétrique par rapport au plan de symétrie (11).

10. Ensemble optique (2) selon l'une quelconque des revendications 1 à 6, les puces semi-conductrices (3) étant disposées sur le support (4) de telle sorte, et l'élément optique (5) étant conçu et disposé de telle sorte que le rayonnement émis par l'ensemble optique (2) est isotrope.

11. Ensemble optique (2) selon la revendication 10, le premier segment (6) étant entièrement entouré par le deuxième segment (8), et les puces semi-conductrices (3) étant disposées, tout autour d'un plan de symétrie (11) de l'élément optique (5), au sein du premier segment (6).

12. Ensemble optique (2) selon l'une quelconque des revendications 1 à 6, les puces semi-conductrices (3) étant disposées sur le support (4) de telle sorte, et l'élément optique (5) étant conçu et disposé de telle sorte qu'une grande partie du rayonnement émis par l'ensemble optique (2) est émise dans une zone d'angle supérieure ou égale à 90° par rapport à la perpendiculaire des surfaces actives des puces semi-conductrices (3).

13. Ensemble optique (2) selon la revendication 12, le premier segment (6) étant disposé dans une zone périphérique de l'élément optique (5) et les puces semi-conductrices (3) étant disposées dans une zone périphérique du support (4) au sein du premier segment (6).

14. Dispositif d'éclairage (1) pour éclairer des surfaces, présentant :
- au moins un ensemble optique (2) selon l'une quelconque des revendications précédentes,
- un boîtier (14), ledit boîtier (14) présentant un fond réfléchissant (15), l'ensemble optique (2) étant disposé sur le fond réfléchissant, ledit fond réfléchissant (15) étant conçu pour réfléchir le rayonnement émis par l'ensemble optique (2) et une répartition irrégulière des puces semi-conductrices (3) au-dessus du fond réfléchissant (15) du boîtier (14) étant atteinte par l'agencement irrégulier des puces semi-conductrices (3) sur le support (4) de l'ensemble optique (2).
